# EUROPEAN PATENT SPECIFICATION

(11) **EP 0 977 474 B1**
(45) Date of publication and mention of the grant of the patent: **01.06.2005**
(21) Application number: 99114474.2
(22) Date of filing: 23.07.1999
(51) Int. Cl.: H05K 9/00

(54) **Shielding of low frequency electromagnetic fields**
Abschirmung gegen elektromagnetisches Feld niedriger Frequenz
Blindage contre les champs électromagnétiques basses fréquences

(30) Priority: 29.07.1998 IT RM980503
(43) Date of publication of application: 02.02.2000
(73) Proprietor: SCT Steel Consulting Terni S.r.l., 05100 Terni (IT)
(72) Inventor: Gubiotti, Roberto, 05100 Terni (IT)
(74) Representative: Gervasi, Gemma, Dr.

(56) References cited:
- DE-A- 4 205 102
- GB-A- 2 225 327
- US-A- 5 045 637
- PATENT ABSTRACTS OF JAPAN vol. 015, no. 240 (E-1079), 20 June 1991 (1991-06-20) & JP 03 073598 A (MITSUBISHI ELECTRIC CORP), 28 March 1991 (1991-03-28)
- PATENT ABSTRACTS OF JAPAN vol. 015, no. 200 (E-1070), 22 May 1991 (1991-05-22) & JP 03 054895 A (BOUON KOGYO KK), 8 March 1991 (1991-03-08)

## Description

The present invention refers to the shielding of low frequency electromagnetic fields, and refers especially to a system of panels useful to prevent or at least significantly attenuate the penetration of these fields in residential or occupational environments or where there are electronic or medical equipment, or in means of transport, or to prevent these fields from spreading outside the environments in which they were generated, such as primary and secondary transformer rooms.

### STATE OF THE ART

The influence of electromagnetic fields on the environment and in particular on health is a widely debated problem, which up till now has found numerous solutions especially as regards the high and very high frequency fields (for example, in telephone technology, radio and television VHF and UHF, radar and similar).

However, the problem of low frequency fields, such as those deriving from high voltage lines, transformer systems and similar, though with frequency generally less than 200 Hz, and in particular between 50 and 70 Hz, has been dealt with only sporadically, also because the investigations carried out so far with reference to the possible long term effects on persons of low frequency fields have not proved to be conclusive. In any case, the growing general involvement in themes of environmental protection and the suspicion that the exposure to electromagnetic fields may cause damage to persons, require effective solutions of the problem.

A first proposal refers to intervention directly on the aerial high voltage lines or on the bus bars of transformer rooms, which ought to use suitable insulated leads, thus making it possible to bring the leads much closer together and in this way to reduce the electromagnetic field produced. However, this solution could affect on the short term only newly installed lines and rooms, as it is clearly not possible to replace rapidly all the leads of the present high voltage lines and transformer rooms, and it would also be very expensive.

It has therefore been proposed to protect residential environments with shields made of metal sheets fixed to the walls, floors and ceilings.

At the present state of knowledge, the best attenuation values are obtained making use of shields made of Permalloy or similar alloys.

The disadvantage of this solution is its considerably high cost, due to the alloys used.

The published Japanese patent application JP 8307086 of 22.11.96 describes a layer of magnetic shielding to be applied on both surfaces of a space to be shielded along a vertical plane. This solution concerns only high voltage lines and presents the problems of cost and of adaptation to the individual environments to be protected, as indicated above.

The published Japanese patent application JP 9195410 of 29.07.1997 refers to a panel structure, of suitable thickness and mechanical resistance, composed of "a couple of coating materials" laid in parallel with sufficient space between them; a couple of electrical steel sheets are inserted in this space, supported and insulated by insulating materials such as rock wool, polyurethane, etc. It is intended for use in operating theatres or in laboratories where electronic equipment is used.

These indications appear not to be well defined or functional, which shows that the known technology has not yet solved the problems of simplicity of use, low cost and high efficiency, which are necessary for shielding environments, even single ones.

### DESCRIPTION OF THE INVENTION ,

The present invention aims to provide shielding for residential or occupational environments, electronic or electromedical installations, laboratories, means of transport and similar applications, against low frequency magnetic fields, this shielding being simple to make and to use, and providing high attenuation of these fields at relatively low costs.

The shielding according to the present invention comprises a set of modular multilayer panels, each panel being composed of at least two layers of metal plates, and in which at least two of such layers are composed of oriented grain electrical silicon steel sheets. In each layer the sheets are arranged in such a way as to present their directions of easy magnetisation at right angles to the ones of the other layer sheets. Preferably, the oriented grain steel is of the high permeability type; the best results may be obtained with a silicon content lower than 2.5% by weight, in particular between 1.5 and 2% by weight.

In particular, for the shielding of environments in the vicinity of long-distance lines and of transformer rooms, it is decisive to use plates with high permeability values at low magnetic field values, for example around 4 A/m.

It is possible to add a further layer of aluminium or aluminium alloy to these two layers of steel sheet, allowing a further high attenuation of the magnetic field; in this case the panel will be mounted with the layer of aluminium arranged immediately towards the source of the magnetic field.

For this application it is preferable to use aluminium with purity higher than 99%, for example grades 1050 or, even better, 1350, in all cases in the annealed state. It is not necessary for these panels to be mounted in such a way as to present complete continuity of the metal sheets; in fact it is possible to have a distance of less than 10 mm between the edges of the metal layers, preferably between 0 and 4 mm.

Alternatively, where possible it is preferable to use panels with T-shaped cross sections, in which the thickness of the horizontal part and the height of the vertical part are substantially equal, and with the metal layers arranged within the thickness of the horizontal part. In this way, in assembling the panels it is possible to obtain a layer of uniform thickness by overlapping the protruding edges of the panels and limiting the problem of the continuity of the attenuating metal layer. This solution will be explained in greater detail below.

For the shielding of horizontal surfaces, such as ceilings, and therefor of the floors above them, it is possible to lay the panels each one in a support of its own, which is then hung on the ceiling. For example it is possible to lay a network of cables, sections or rods with a mesh of the desired dimensions, to hang plastic baskets from this network and place a panel in each basket; in this way it is possible to keep the edges of each panel at the prescribed distance from the edges of the neighbouring panels.

On account of the good attenuation values reached, the present invention is particularly suitable for shielding high density fields, such as those deriving from lines with a high current intensity which are very close to the environment that is to be protected, as in the case of lines for high speed trains which can reach magnetic field values of 80-100 µT at a distance of 2 metres.

The present invention will now be described in greater detail with reference to some possible embodiments, given purely as an example and without limiting the scope and range of the invention itself, making reference to the enclosed drawings in which:
Fig. 1 is the diagram for making the multilayer panels for shielding vertical walls, with respective T junctions;
Fig. 2 is the "cell" diagram for shielding norizontal surfaces (ceilings);
Fig. 3 is the diagram for the assembly of panels with T junctions on the wall to be shielded.

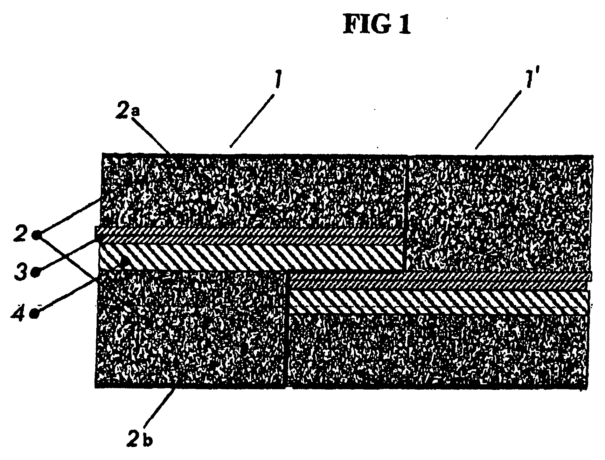

With reference to Fig. 1, which shows the overlapping edges of two adjacent panels 1 and 1' together with the general structure of the panels themselves, (i) 2 indicates a layer of the panel, not active for the purposes of the present invention, which may for example be made of wood, plastic laminate, foamed material, plasterboard or similar, (ii) 3 indicates the two layers of magnetic material with oriented grain and (iii) 4 indicates a possible layer of conductive material, in particular high-purity aluminium.

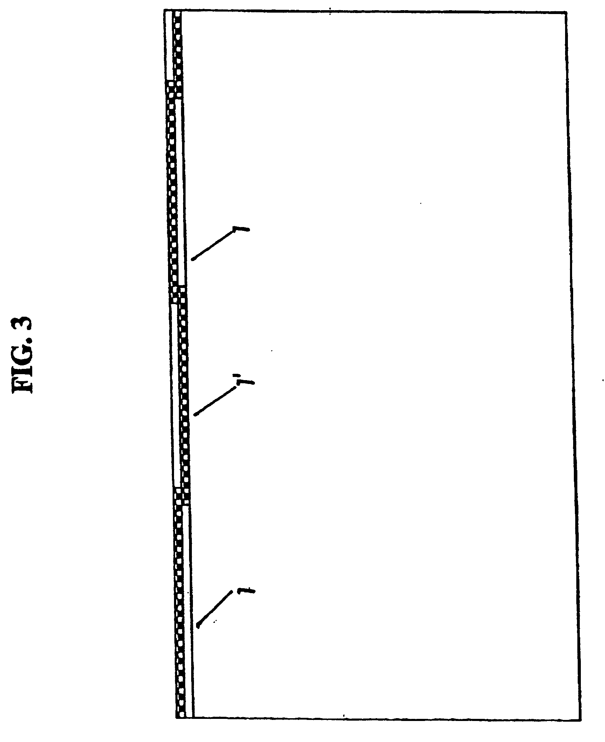

In practice, the panels may be considered to be composed of a first quadrangular layer 2b to which are overlapped two crossed layers 3 of metal sheets with oriented grain and high magnetic characteristics, and possibly a further layer 4 of high-purity aluminium. The panel is completed by a second coating layer 2b, also quadrangular, protruding beyond the edges of the first layer 2b. In this way, adjacent panels may be assembled in inverse positions to one another, as shown in Fig. 3, thus greatly attenuating the effects of the non continuity of the metal layers.

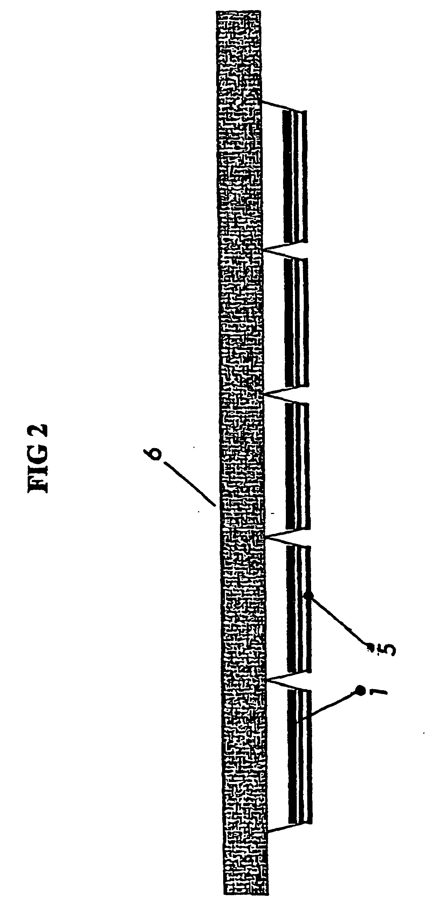

Fig. 2 shows multilayer panels 1 housed in trays 5, for example plastic trays, hanging below a floor 6. It is possible to make these trays in such a way that the metal edges of the panels in adjacent trays are at a distance of less than 10 mm from each other, preferably less than 4 mm.

Panels of the type illustrated in Figures 1 and 2 were used to cover ceilings and walls in an environment subjected to a magnetic field with a value of 2.5 µT measured at a distance of 1 metre from the walls and 1.5 metres from the ceiling. Three different combinations of shielding materials were used, and in particular:
- M5T30 type oriented grain sheets, 0.30 mm thick, permeability µ4 = 16360 mT, in a double layer with directions of easy magnetisation perpendicular to each other;
- high permeability oriented grain electrical steel sheets, type M0T30, 0.30 mm thick, permeability µ4 = 21090 mT, in a double layer with directions of easy magnetisation perpendicular to each other;
- double layer sheet, as in the previous case but with a further layer of aluminium type 1050, 2 mm thick, facing the source of the magnetic field.

The magnetic field values measured at a distance of 1 metre from the walls and 1.5 metres from the ceiling were:
- without shielding 2.5 µT;
- with shielding type 1, 0.29 µT with an attenuation factor of 8.6;
- with shielding type 2, 0.18 µT with an attenuation factor of 13.9;
- with shielding type 3, 0.09 µT with an attenuation factor of 27.8.

Furthermore, with a field of 80 µT, generated by a 25,000 V line, attenuation values of 11.4 were obtained with panels of type 3, at a distance of 2.5 m.

## Claims

1. Shielding panel (1, 1') against low frequency magnetic fields, comprising at least two layers of metal sheet (3), **characterised in that** at least two metal layers (3) are composed of grain oriented electrical silicon steel sheet, said oriented grain electrical steel sheets having their relevant direction of easy magnetisation perpendicular to each other.

2. Panel according to claim 1, wherein said oriented grain silicon steel sheet has a silicon content lower than 2.5% by weight.

3. Panel according to claim 2, wherein said silicon content is between 1.5 and 2% by weight.

4. Panel according to any one of the previous claims, wherein a further aluminium layer (3) is added to said two layers (3) of metal sheets.

5. Panel according to claim 3, wherein said aluminium layer (4) has a purity higher than 99%.

6. Set of panels according to any one of the previous claims, wherein the distance between the edges of the metal layers (3, 4) is, on a plane coinciding with the one of the metal strips, less then 10 mm.

7. Set of panels according to claim 6, wherein the distance between said edges is between 0 and 4 mm.

8. Panel according to any one of claims 1 to 5, wherein the cross section of the panel is T-shaped, the thickness of the horizontal part of it and the height of the vertical part being substantially equal, the metal layers being arranged within the thickness of the horizontal part.

9. Set of panels for shielding rooms with horizontal surfaces according to any one of claims 6-7, wherein each panel is inserted in a support (5) hanging below said horizontal surfaces (6).

10. Set of panels according to claim 9, wherein said supports (5) are baskets hooked onto a network of hanging elements arranged below said horizontal surface.

11. Use of panels according to any one of the previous claims to shield residential or occupational environments, electronic or electromedical installations, laboratories or means of transport against low frequency magnetic fields.

12. Use of panels according to any of the claims from 1 to 10 to shield high speed trains against low frequency magnetic fields.

## Patentansprüche

1. Abschirmplatte (1,1') gegen Magnetfelder niedriger Frequenz, die wenigstens zwei Blechschichten (3) umfasst, **dadurch gekennzeichnet, dass** wenigstens zwei Metallschichten (3) aus kornorientiertem elektrischem Siliciumstahlblech zusammengesetzt sind, wobei die relevanten Richtungen der leichten Magnetisierung der genannten elektrischen Stahlbleche mit orientiertem Korn senkrecht zueinander sind.

2. Platte gemäß Anspruch 1, bei der das genannte Siliciumstahlblech mit orientiertem Korn einen Siliciumgehalt von unter 2,5 Gew.-% besitzt.

3. Platte gemäß Anspruch 2, bei der der genannte Siliciumgehalt zwischen 1,5 und 2 Gew.-% liegt.

4. Platte gemäß einem der vorherigen Ansprüche, bei der zu den zwei genannten Blechschichten (3) eine weitere Aluminiumschicht (3) hinzugefügt ist.

5. Platte gemäß Anspruch 3, bei der die genannte Aluminiumschicht (4) eine Reinheit von über 99 % besitzt.

6. Satz von Platten gemäß einem der vorherigen Ansprüche, bei dem der Abstand zwischen den Rändern der Metallschichten (3, 4) in einer Ebene, die mit dem einen der Metallstreifen zusammenfällt, weniger als 10 mm ist.

7. Satz von Platten gemäß Anspruch 6, bei dem der Abstand zwischen den genannten Rändern zwischen 0 und 4 mm liegt.

8. Platte gemäß einem der Ansprüche 1 bis 5, bei der der Querschnitt der Platte T-förmig ist, die Dicke ihres horizontalen Teils und die Höhe des vertikalen Teils im Wesentlichen gleich sind und die Metallschichten innerhalb der Dicke des horizontalen Teils angeordnet sind.

9. Satz von Platten für Abschirmräume mit horizontalen Oberflächen gemäß einem der Ansprüche 6-7, bei dem jede Platte in einen Träger (5) eingesetzt ist, der unter den genannten horizontalen Oberflächen (6) hängt.

10. Satz von Platten gemäß Anspruch 9, bei dem die genannten Träger (5) Körbe sind, die in ein Netz von Hängeelementen eingehakt sind, das unter der genannten horizontalen Oberfläche angeordnet ist.

11. Verwendung von Platten gemäß einem der vorherigen Ansprüche zum Abschirmen von Wohn- oder Arbeitsumgebungen, elektronischen oder elektromedizinischen Anlagen, Labors oder Transportmitteln gegen elektromagnetische Felder niedriger Frequenz.

12. Verwendung von Platten gemäß einem der Ansprüche 1 bis 10 zum Abschirmen von Hochgeschwindigkeitszügen gegen Magnetfelder niedriger Frequenz.

## Revendications

1. Panneau de blindage (1, 1') contre des champs magnétiques basses fréquences, comprenant au moins deux couches de feuilles métalliques (3), **caractérisé en ce qu'**au moins deux couches métalliques (3) sont composées de feuille d'acier magnétique au silicium à grains orientés, lesdites feuilles d'acier magnétique à grains orientés présentant leur direction pertinente de magnétisation aisée perpendiculaire l'une à l'autre.

2. Panneau selon la revendication 1, dans lequel ladite feuille d'acier au silicium à grains orientés présente une teneur en silicium inférieure à 2,5% en poids.

3. Panneau selon la revendication 2, dans lequel ladite teneur en silicium est entre 1,5 et 2% en poids.

4. Panneau selon l'une quelconque des revendications précédentes, dans lequel une couche supplémentaire d'aluminium (3) est ajoutée auxdites deux couches (3) de feuilles métalliques.

5. Panneau selon la revendication 3, dans lequel ladite couche d'aluminium (4) présente une pureté supérieure à 99%.

6. Jeu de panneaux selon l'une quelconque des revendications précédentes, dans lequel la distance entre les bords des couches métalliques (3, 4) est, sur un plan qui coïncide avec celui des bandes métalliques, inférieure à 10 mm.

7. Jeu de panneaux selon la revendication 6, dans lequel la distance entre lesdits bords est entre 0 et 4 mm.

8. Panneau selon l'une quelconque des revendications 1 à 5, dans lequel la section transversale du panneau est en forme de T, l'épaisseur de la partie horizontale de celui-ci et la hauteur de la partie verticale étant sensiblement égales, les couches métalliques étant disposées dans l'épaisseur de la partie horizontale.

9. Jeu de panneaux pour le blindage de locaux présentant des surfaces horizontales selon l'une quelconque des revendications 6-7, dans lequel chaque panneau est inséré sur un support (5) suspendu en dessous desdites surfaces horizontales (6).

10. Jeu de panneaux selon la revendication 9, dans lequel lesdits supports (5) sont des paniers accrochés à un réseau d'éléments de suspension disposés en dessous de ladite surface horizontale.

11. Utilisation de panneaux selon l'une quelconque des revendications précédentes pour blinder des environnements d'habitation ou de travail, des installations électroniques ou électro-médicales, des laboratoires ou des moyens de transport, contre des champs magnétiques basses fréquences.

12. Utilisation de panneaux selon l'une quelconque des revendications 1 à 10 pour blinder des trains à grande vitesse contre des champs magnétiques basse fréquence.
